# FASCICULE DE BREVET EUROPEEN

(11) **EP 0 892 442 B1**
(45) Date de publication et mention de la délivrance du brevet: **25.09.2002**
(21) Numéro de dépôt: 98401680.8
(22) Date de dépôt: 03.07.1998
(51) Int. Cl.: H01L 29/92, H01L 21/3205

(54) **Procédé de fabrication d'une capacité métal-métal au sein d'un circuit intégré, et circuit intégré correspondant**
Verfahren zur Herstellung einer Metall-Metall-Kapazität in einer integrierten Schaltung und entsprechende integrierte Schaltung
Process for manufacturing a metal-metal capacity in an integrated circuit and corresponding integrated circuit

(30) Priorité: 18.07.1997 FR 9709164
(43) Date de publication de la demande: 20.01.1999
(73) Titulaire: STMicroelectronics S.A., 92120 Montrouge (FR); FRANCE TELECOM, 75015 Paris (FR)
(72) Inventeur: Jaouen, Hervé, 38240 Meylan (FR); Marty, Michel, 38760 Varces (FR)
(74) Mandataire: Casalonga, Axel

(56) Documents cités:
- EP-A- 0 188 946
- EP-A- 0 749 167
- EP-A- 0 771 022

## Description

L'invention concerne les capacités métal-métal réalisées au sein d'un circuit intégré, et leur procédé de fabrication.

Parmi les différents types de capacités pouvant figurer au sein d'un circuit intégré réalisé sur une pastille semi-conductrice, par exemple du silicium, on peut citer les capacités dites "polysilicium-silicium", ou "polysilicium-polysilicium", ou encore "métal-métal", en fonction de la composition de leurs électrodes.

Les capacités dites "métal-métal", c'est-à-dire dont les deux électrodes sont métalliques, offrent l'avantage de présenter une très faible variation de la valeur de capacité en fonction de la tension qui leur est appliquée, et de posséder en outre un élément résistif parasite très faible. Pour toutes ces raisons, les capacités métal-métal sont avantageusement utilisées dans les applications radiofréquence.

Un circuit intégré comporte généralement des composants électroniques, par exemple des transistors, réalisés au sein d'un substrat semiconducteur, ainsi que différents niveaux de métallisation permettant de réaliser notamment des pistes d'interconnexion entre les différents composants du circuit intégré. Chaque niveau de métallisation comporte alors généralement, après gravure d'une couche métallique, plusieurs pistes d'interconnexion situées à ce même niveau et toutes prises en sandwich entre deux couches isolantes. Le niveau de métallisation immédiatement supérieur est alors réalisé sur la couche isolante supérieure recouvrant le niveau de métallisation inférieur. L'interconnexion entre des pistes situées à deux niveaux de métallisation adjacents est réalisée par des trous d'interconnexion remplis d'un métal de remplissage, par exemple du tungstène, et communément appelé par l'homme du métier des vias. Par ailleurs, on réalise à l'interface aluminium-tungstène une barrière de diffusion intermétal par dépôt d'une couche de protection généralement en nitrure de titane ou en titane.

L'épaisseur classique d'une couche isolante séparant deux niveaux de métallisation adjacents, est généralement de l'ordre de 1 micron. Il n'est donc pas possible de réaliser directement une capacité métal-métal entre deux portions de piste situées à deux niveaux de métallisation différents séparés par une telle épaisseur. En effet, la couche diélectrique d'une capacité métal-métal doit être de l'ordre de 200Å typiquement.

Aussi, un procédé connu de fabrication d'une capacité métal-métal au sein d'un circuit intégré consiste à déposer sur la couche isolante inférieure de support d'un niveau de métallisation, recouverte d'une couche de protection, par exemple en nitrure de titane, une couche d'aluminium formant un niveau de métallisation (cette couche de protection résultant de la présence en un autre endroit du circuit intégré d'un via connectant ce niveau de métallisation à un niveau de métallisation inférieur ou bien à un composant réalisé dans le substrat). On grave ensuite cette couche d'aluminium de façon à définir notamment la première électrode de la capacité, puis on dépose sur cette première électrode et sur l'ensemble des pistes d'interconnexion du niveau de métallisation, la couche isolante supérieure recouvrant ce niveau de métallisation et destinée à supporter le niveau de métallisation immédiatement supérieur. On grave alors dans cette couche isolante supérieure un orifice débouchant au-dessus de la première électrode de la capacité, puis on effectue un dépôt d'une fine couche d'un matériau diélectrique, par exemple généralement du dioxyde de silicium ou éventuellement du nitrure de silicium, d'une épaisseur de 50 à 300 Å environ. On dépose alors sur cette couche diélectrique une autre couche de protection permettant le contact de ce niveau de métallisation avec un autre via en un autre endroit du circuit intégré. Puis on remplit, par dépôt puis aplanissement, ledit orifice avec du métal de remplissage, typiquement du tungstène. Après avoir déposé une couche de barrière de diffusion intermétal sur le tungstène, on dépose la couche métallique (aluminium) du niveau de métallisation immédiatement supérieur que l'on grave de façon à réaliser les pistes d'interconnexion de ce niveau de métallisation, ainsi que la deuxième électrode de la capacité métal-métal.

Un tel procédé présente des inconvénients.

En effet, il ne permet pas de contrôler précisément l'épaisseur du diélectrique de la capacité ainsi réalisée, en particulier lorsque celui-ci est composé de dioxyde de silicium, car la couche de protection en TiN attaque le matériau diélectrique de la capacité. En outre, d'une façon générale, ce procédé ne permet de réaliser que des capacités métal-métal planes. Par ailleurs, la capacité ainsi réalisée s'étend sur deux niveaux de métallisation du circuit intégré.

L'invention vise à apporter une solution à ces problèmes.

Un but de l'invention est de pouvoir réaliser des capacités non nécessairement planes.

Un autre but de l'invention est de proposer un procédé de fabrication d'une capacité métal-métal, permettant de mieux contrôler l'épaisseur du diélectrique, notamment lorsque celui-ci est composé de SiO₂.

L'invention propose donc un procédé de fabrication d'une capacité métal-métal au sein d'un circuit intégré, le circuit intégré comportant des niveaux de métallisation respectivement supportés par des couches isolantes inférieures et recouverts par des couches isolantes supérieures, cette capacité comportant deux électrodes métalliques au contact de part et d'autre d'une couche diélectrique plus fine qu'une couche isolante séparant deux niveaux de métallisation. Selon l'invention, on réalise au-dessus d'une couche isolante inférieure une première couche métallique formant un niveau de métallisation du circuit intégré, et on grave ladite première couche de façon à former une première électrode de la capacité. Lorsque l'on utilise pour les pistes d'interconnexion et les électrodes métalliques de la capacité, un matériau classique, tel que de l'aluminium, la première couche métallique est généralement déposée sur une couche de protection, typiquement en nitrure de titane, recouvrant la couche isolante inférieure, typiquement en SiO₂. Cette couche de protection résulte généralement de la nécessité d'avoir disposé en un autre endroit du circuit intégré une barrière de diffusion entre un via en tungstène et cette première couche métallique.

On dépose alors sur la première couche métallique ainsi gravée la fine couche d'un matériau diélectrique, généralement du dioxyde de silicium (SiO₂), puis on dépose sur la couche diélectrique une deuxième couche métallique, par exemple de l'aluminium ou du tungstène, plus fine que la première. On grave cette deuxième couche métallique pour former la deuxième électrode de la capacité et on dépose sur la deuxième couche métallique ainsi gravée ladite couche isolante supérieure recouvrant ledit niveau de métallisation. Cette couche isolante supérieure sera avantageusement en pratique la couche isolante de support du niveau de métallisation immédiatement supérieur.

En d'autres termes, l'invention est remarquable en ce sens qu'elle permet de réaliser une capacité métal-métal sur quasiment un niveau de métallisation, alors que l'art antérieur en prévoit deux. En outre, on n'utilise plus de couche de protection en nitrure de titane au contact du matériau diélectrique.

Par ailleurs, selon un mode de mise en oeuvre préféré de l'invention, on ménage, lors de la gravure de la première couche métallique, au moins un flanc latéral pour ladite première électrode et, après dépôt de la couche diélectrique sur le flanc, on grave la deuxième couche métallique déposée sur la couche diélectrique de façon à réaliser pour la deuxième électrode, une portion latérale au contact de la couche diélectrique et en face dudit flanc latéral.

En d'autres termes, l'invention permet ici de réaliser des capacités non planes, c'est-à-dire ayant en l'espèce un flanc vertical, ce qui permet en particulier d'augmenter la surface de la capacité tout en contrôlant les contraintes mécaniques.

Lorsque l'on souhaite relier la deuxième électrode de la capacité au niveau de métallisation supérieur, par exemple pour la connecter à un autre composant, on grave un orifice dans la couche isolante supérieure que l'on remplit d'un métal de remplissage de façon à former un trou d'interconnexion métallique ou via, et on réalise au-dessus de ladite couche isolante supérieure et en contact électrique avec le trou d'interconnexion métallique, une troisième couche métallique correspondant à un niveau de métallisation supérieur.

L'invention a également pour objet un circuit intégré comprenant des niveaux de métallisation respectivement supportés par des couches isolantes inférieures et recouverts par des couches isolantes supérieures, et une capacité métal-métal comportant deux électrodes métalliques disposées de part et d'autre et au contact d'une couche diélectrique plus fine qu'une couche isolante séparant deux niveaux de métallisation.

Selon une caractéristique générale de l'invention, les deux électrodes métalliques et la couche diélectrique sont situées entre la couche isolante inférieure supportant un niveau de métallisation du circuit intégré et la couche isolante supérieure recouvrant ce niveau de métallisation, et

la première électrode est une partie de la couche métallique formant ledit niveau de métallisation et la deuxième électrode est plus fine que la première électrode.

Selon un mode de réalisation préférentiel de l'invention, la première électrode comporte un flanc latéral recouvert d'une partie de la couche diélectrique, elle-même recouverte d'une partie de la deuxième électrode. La capacité selon l'invention n'est donc pas nécessairement plane.

D'autres avantages et caractéristiques de l'invention apparaîtront à l'examen de la description détaillée de modes de mise en oeuvre et de réalisation, nullement limitatifs, et des dessins annexés, sur lesquels :

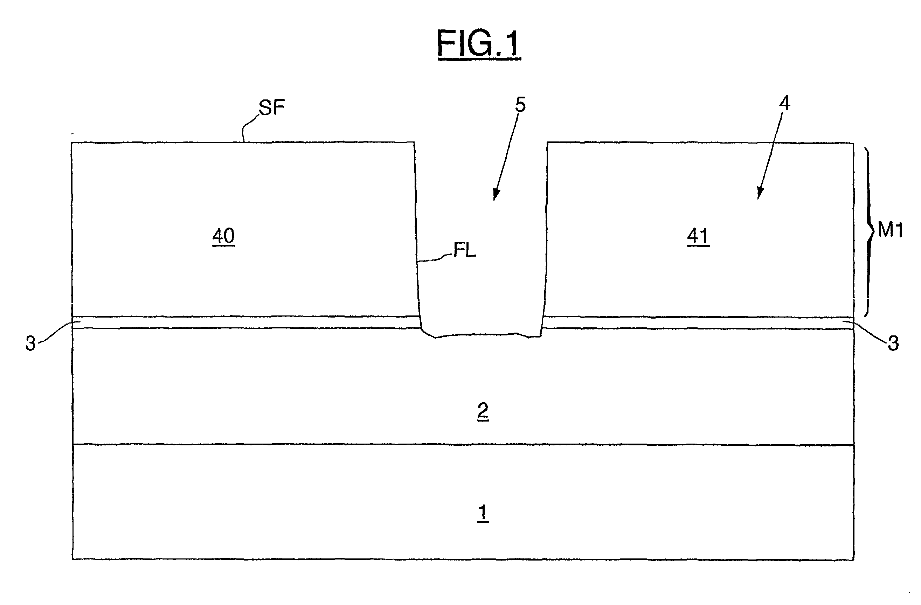

les figures 1 à 10 illustrent très schématiquement les différentes étapes d'un mode de mise en oeuvre du procédé selon l'invention, permettant l'obtention d'une capacité métal-métal selon l'invention.

Sur la figure 1, la référence 1 désigne un substrat semi-conducteur, par exemple du silicium. Ce substrat est surmonté d'une couche isolante inférieure 2 destinée, comme on le verra ci-après, à supporter le niveau de métallisation M1 du circuit intégré, que l'on suppose être dans l'exemple décrit le premier niveau de métallisation. Cette couche isolante, par exemple de dioxyde de silicium, peut faire l'objet d'un dépôt assisté thermiquement (dépôt TEOS) à basse température, typiquement inférieure à 400°C. L'épaisseur de cette couche isolante inférieure est classiquement de l'ordre de 1 micron.

Sur cette couche isolante inférieure 2, on dépose une couche de protection 3, d'une épaisseur de 500 à 1000 Å, généralement à base de titane ou de nitrure de titane. Cette couche 3 résulte de la présence, en un autre endroit du circuit intégré, d'un via destiné par exemple à connecter un composant réalisé dans le substrat 1 au niveau de métallisation M1 supporté par la couche isolante 2. La fonction de cette couche 3 est de réaliser une barrière de diffusion intermétal entre le métal du via (tungstène) et celui du niveau de métallisation M1 (aluminium).

La première couche métallique 4 déposée, est destinée, après gravure, par exemple une gravure sèche par plasma, à former notamment les différentes pistes d'interconnexion du circuit intégré situé au premier niveau de métallisation M1. Outre la formation par gravure de ces pistes d'interconnexion, le masque de gravure utilisé permet de former dans la première couche métallique 4, la première électrode métallique 40 de la future capacité métal-métal. Cette première électrode 40 comporte une surface supérieure plane SF, et est séparée du reste 41 de la première couche métallique 4 par un orifice 5 s'étendant jusqu'au niveau de la couche isolante inférieure 2, et ménageant pour la première électrode métallique 30 un flanc latéral sensiblement vertical FL. L'épaisseur de cette première couche métallique est typiquement de l'ordre de 0,6 micron.

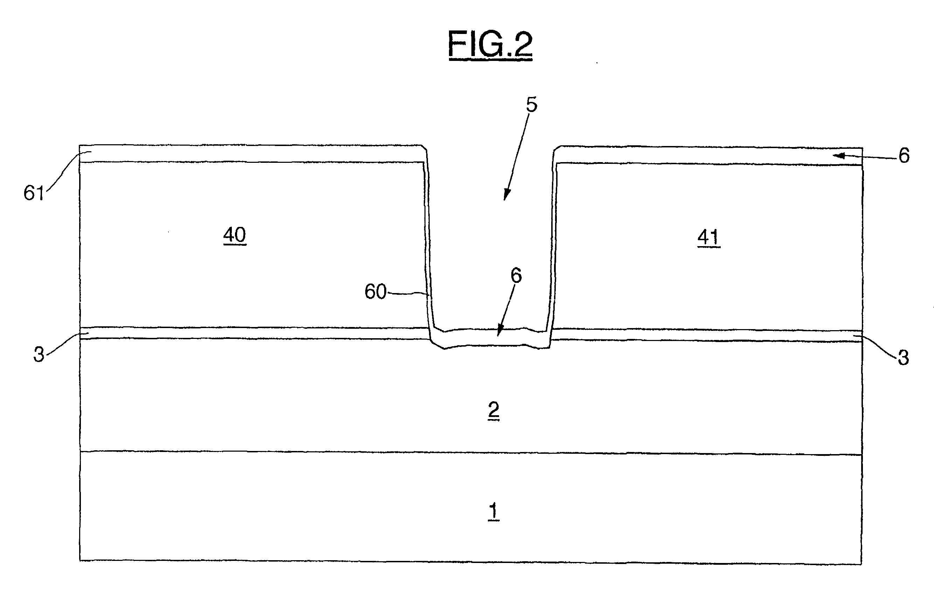

L'étape suivante consiste (figure 2) à déposer sur l'empilement de couches de la figure 1, une fine couche 6 formée d'un matériau ayant des propriétés diélectriques, généralement du dioxyde de silicium (SiO₂) ou bien par exemple du nitrure de silicium (Si₃N₄) ou encore de l'oxyde de tantale (Ta₂O₅). Le matériau de cette couche sera comme on le verra plus en détail ci-après, destiné à former le matériau diélectrique de la capacité métal-métal. L'épaisseur de cette couche 6 est typiquement de l'ordre de 0,02 micron, en particulier au niveau de sa portion plane 61 située sur l'électrode métallique 40. Par contre, la portion verticale 60 de cette couche diélectrique, située sur le flanc vertical de la première électrode, peut présenter une épaisseur légèrement inférieure à celle de la portion plane 61.

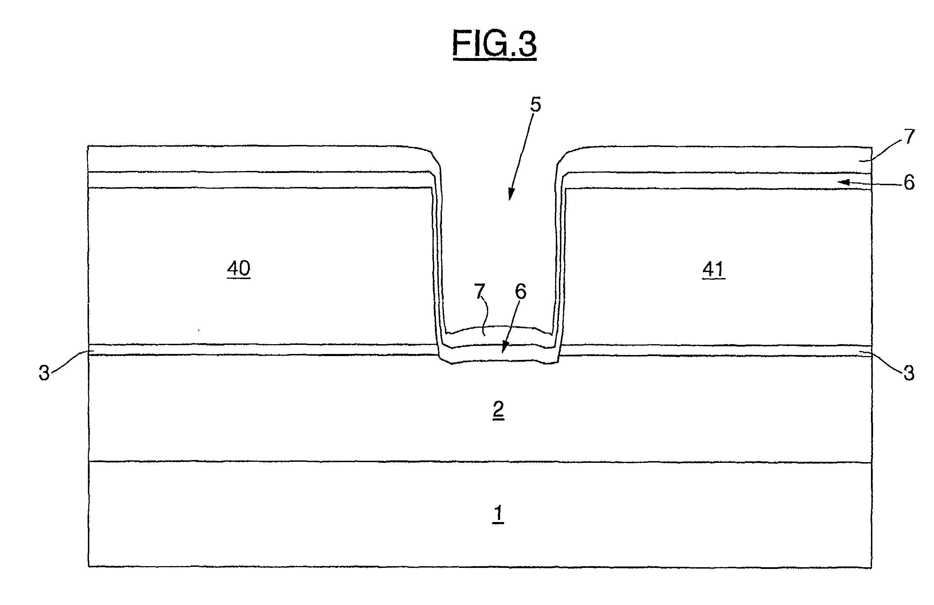

On procède ensuite (figure 3) au dépôt d'une deuxième couche métallique 7, ayant une épaisseur plus faible que celle de la première couche métallique 4, typiquement de l'ordre de 0,1 micron. Cette deuxième couche métallique, par exemple également en aluminium ou bien en tungstène, va permettre de former la deuxième électrode métallique de la capacité métal-métal.

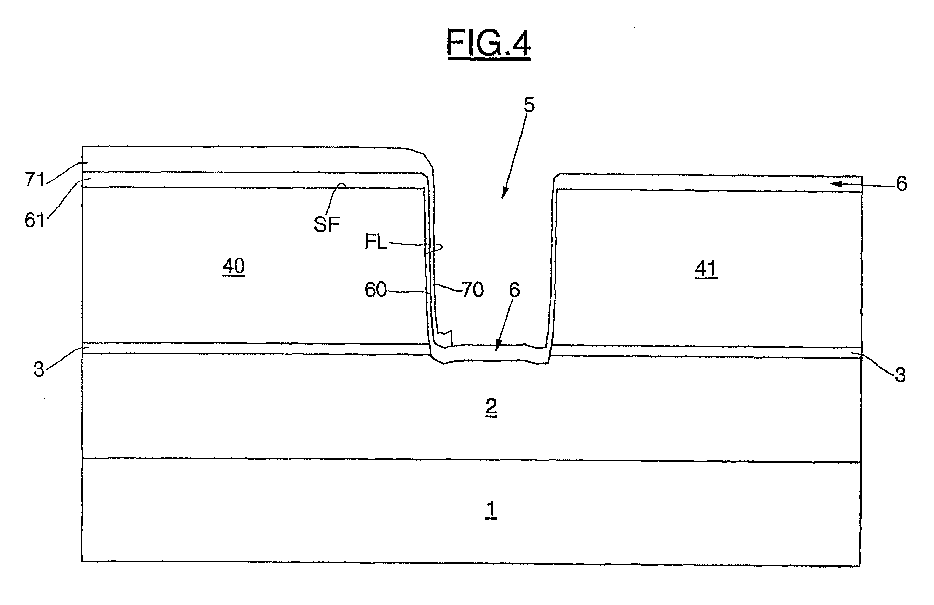

Après gravure de la deuxième couche de métal, par exemple par gravure sèche plasma, on délimite (figure 4) la deuxième électrode métallique de la capacité ayant une partie sensiblement plane 71 en vis-à-vis de la surface plane SF de la première électrode 40, ainsi que (dans le cas où l'on souhaite réaliser une capacité non plane) une partie verticale 70 recouvrant la portion verticale 60 de diélectrique et située en face du flanc vertical latéral FL de la première électrode métallique 40.

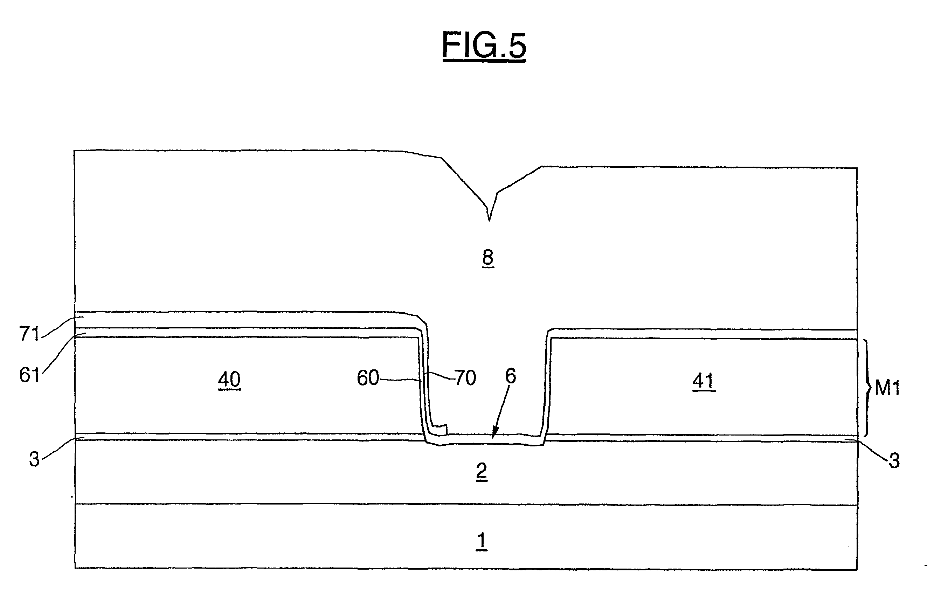

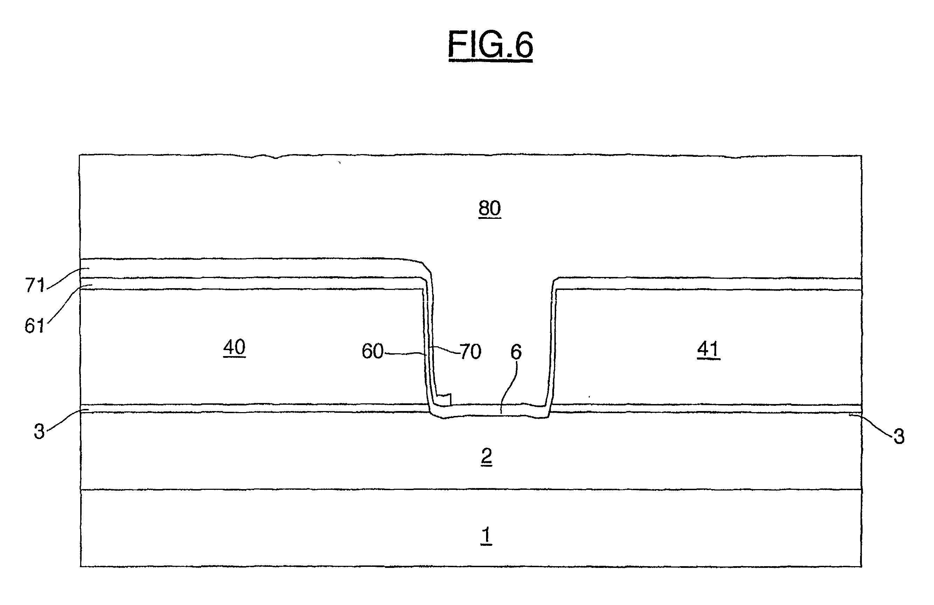

On recouvre ensuite (figure 5) l'ensemble d'une couche isolante 8, par exemple du dioxyde de silicium, que l'on peut également déposer par un dépôt TEOS. Après polissage mécanochimique par exemple, on obtient la couche isolante supérieure 80 ayant une épaisseur typiquement de l'ordre de 0,7 micron (figure 6).

L'invention se distingue de l'art antérieur notamment par le fait que les électrodes de la capacité sont délimitées, non pas, comme dans l'art antérieur, par une gravure d'une couche isolante puis dépôt d'un diélectrique surmonté d'une couche de protection en nitrure de titane elle-même surmontée d'un métal de remplissage puis d'aluminium, mais par gravure directe de la couche métallique d'un niveau de métallisation. Un niveau spécifique fin de métallisation est déposé sur le diélectrique pour former la deuxième électrode. Ce niveau spécifique de métallisation n'est pas destiné à former par ailleurs des pistes susceptibles d'être connectées par des vias au niveau de métallisation immédiatement inférieur. Il en résulte donc qu'un dépôt d'une couche de protection en nitrure de titane sur le diélectrique n'est plus nécessaire, ce qui permet de parfaitement contrôler l'épaisseur du diélectrique, et ce uniquement par l'opération de dépôt, en particulier lorsque le diélectrique est du dioxyde de silicium. En effet, l'inconvénient apporté par le dépôt de nitrure de titane, qui est un réducteur de la silice, est ici supprimé.

Par ailleurs, l'invention permet d'obtenir des capacités métal-métal non nécessairement planes mais pouvant présenter des flancs latéraux, ce qui permet d'en augmenter la surface sans pour autant augmenter la surface générale du circuit intégré.

Enfin, l'homme du métier remarque que selon l'invention, la capacité métal-métal obtenue est réalisée quasiment au sein d'un même niveau de métallisation M1, entre les deux couches isolantes encadrant ce niveau de métallisation, alors que dans l'art antérieur, la capacité métal-métal s'étend sur deux niveaux de métallisation.

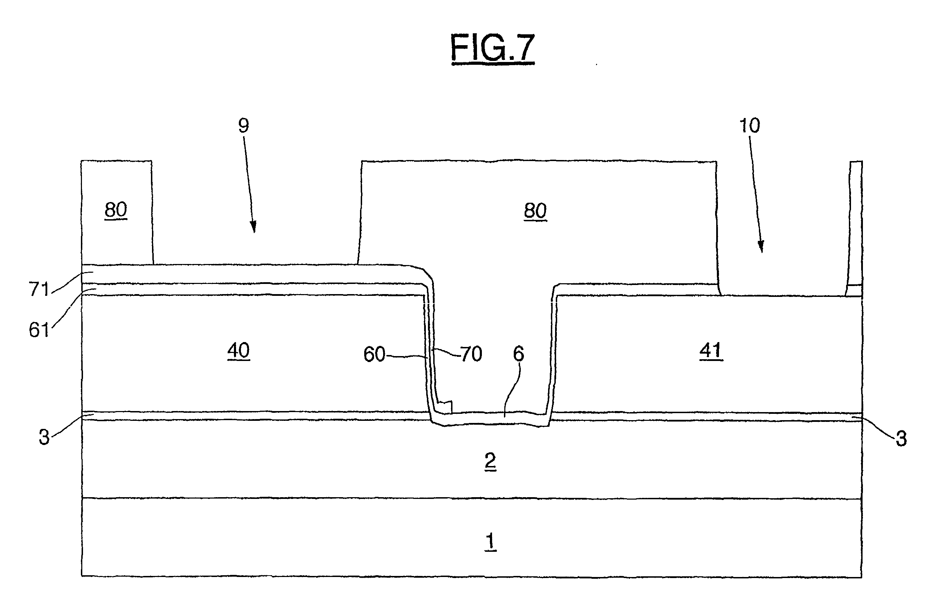

Pour connecter la deuxième électrode métallique 71 de la capacité métal-métal à un niveau de métallisation supérieur du circuit intégré, on procède alors comme illustré plus particulièrement sur les figures 7 à 10.

Plus précisément, on grave dans la couche isolante supérieure 80 un orifice 9 débouchant sur la deuxième électrode métallique 71 de la capacité. Si l'on souhaite également établir une connexion entre le reste 41 de la première couche métallique du niveau de métallisation M1 avec le niveau de métallisation immédiatement supérieur M2, on grave également un orifice 10 débouchant sur cette partie 41.

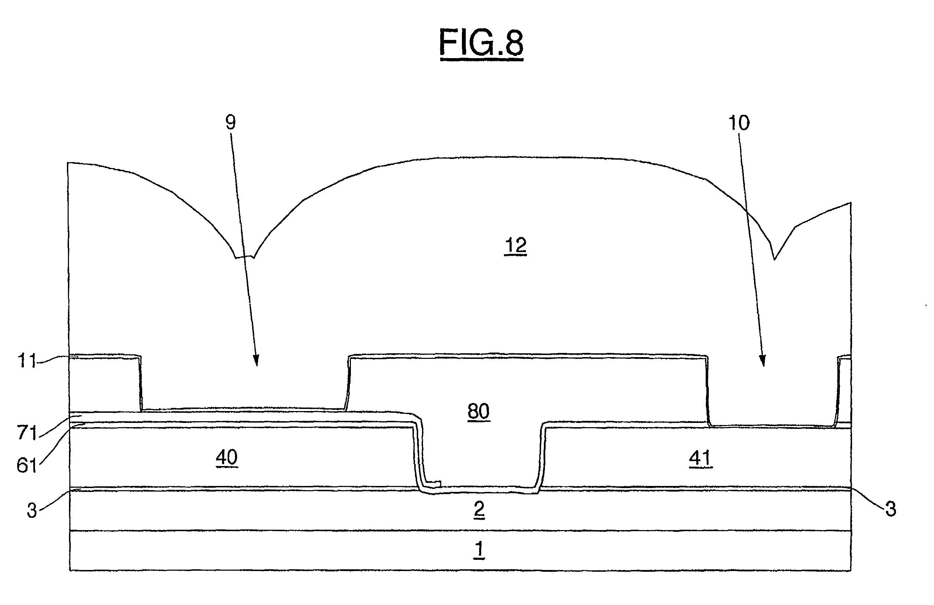

On dépose ensuite (figure 8) sur la couche isolante supérieure 80 gravée, une fine couche de protection 11, formée également de titane ou de nitrure de titane et ayant typiquement une épaisseur de l'ordre de 0,1 micron. Puis, on dépose un matériau 12 de remplissage, par exemple du tungstène, sur l'ensemble ainsi formé.

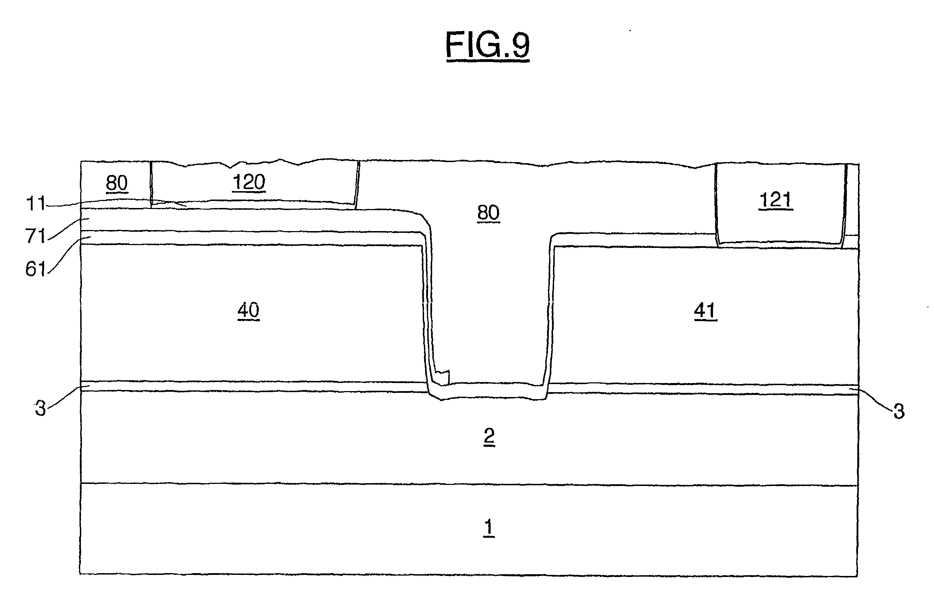

Après polissage mécanochimique de l'ensemble, on obtient (figure 9) deux trous d'interconnexion métallique ou vias 120 et 121. La couche de protection 11 assure là encore une barrière de diffusion pour éviter l'interdiffusion entre l'aluminium et le tungstène.

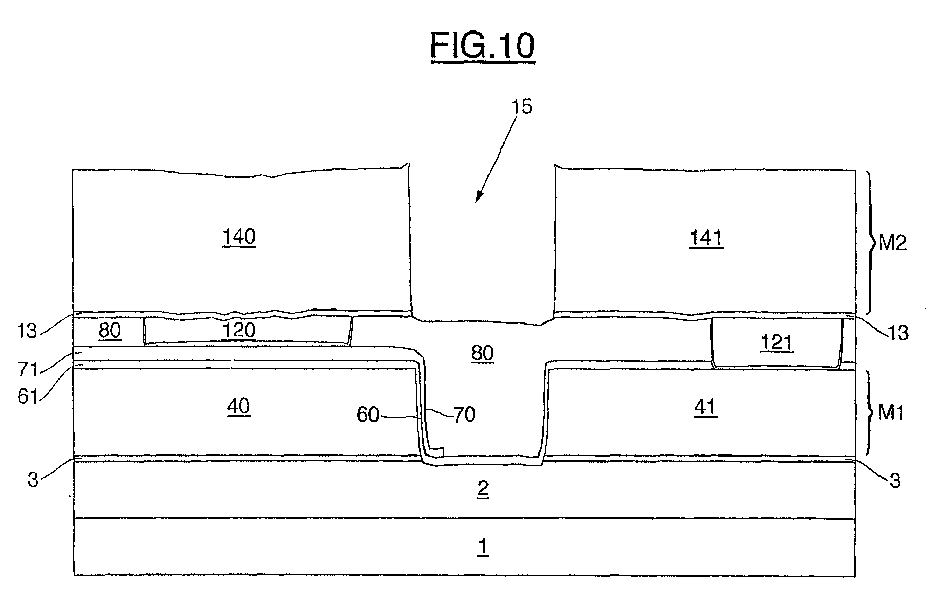

On dépose ensuite (figure 10) une autre couche 13 de titane ou de nitrure de titane sur l'ensemble, puis on dépose une troisième couche métallique en aluminium destinée à former le niveau de métallisation M2 que l'on grave de façon notamment à former un orifice 15 séparant la partie 140 (en contact avec le via 120 et par conséquent avec la deuxième électrode métallique 71 de la capacité métal-métal) de l'autre partie 141 (en contact avec le via 121). La connexion de la deuxième électrode métallique 71 de la capacité métal-métal, peut donc être ainsi réalisée au moyen de la partie métallique 140 du niveau de métallisation immédiatement supérieur M2.

## Revendications

1. Procédé de fabrication d'une capacité métal-métal au sein d'un circuit intégré, le circuit intégré comportant des niveaux de métallisation respectivement supportés par des couches isolantes inférieures (2) et recouverts par des couches isolantes supérieures (80), ladite capacité comportant deux électrodes métalliques au contact de part et d'autre d'une couche diélectrique plus fine qu'une couche isolante séparant deux niveaux de métallisation, **caractérisé par le fait qu'**on, dépose au-dessus d'une couche isolante inférieure (2) une première couche métallique (4) formant un niveau de métallisation (M1) du circuit intégré, on grave ladite première couche (4) de façon à former une première électrode (40) de la capacité, on dépose sur la première couche ainsi gravée la fine couche (6) d'un matériau diélectrique, puis on dépose sur la couche diélectrique une deuxième couche métallique (7) plus fine que la première que l'on grave pour former la deuxième électrode (70, 71) de la capacité, et on dépose sur la deuxième couche métallique ainsi gravée une couche isolante supérieure (80) recouvrant ledit niveau de métallisation (M1).

2. Procédé selon la revendication 1, **caractérisé par le fait que** lors de la gravure de la première couche métallique (4), on ménage au moins un flanc latéral (FL) pour ladite première électrode (40), et après dépôt de la couche diélectrique (6) sur ledit flanc, on grave la deuxième couche métallique déposée sur la couche diélectrique de façon à réaliser pour la deuxième électrode, une portion latérale (70) au contact de la couche diélectrique (60) et en face dudit flanc latéral (FL).

3. Procédé selon l'une des revendications précédentes, **caractérisé par le fait qu'**on grave un orifice (9) dans la couche isolante supérieure (80) que l'on remplit d'un métal de remplissage (12) de façon à former un trou d'interconnexion métallique (120) et on dépose au-dessus de ladite couche isolante (80) et au-dessus du trou d'interconnexion métallique (120) une troisième couche métallique (140) correspondant à un niveau de métallisation supérieur (M2).

4. Circuit intégré, comprenant des niveaux de métallisation respectivement supportés par des couches isolantes inférieures (2) et recouverts par des couches isolantes supérieures (80), et une capacité métal-métal comportant deux électrodes métalliques disposées de part et d'autre et au contact d'une couche diélectrique plus fine qu'une couche isolante séparant deux niveaux de métallisation, **caractérisé par le fait que** les deux électrodes métalliques (40, 71) et la couche diélectrique (61) sont situées entre la couche isolante inférieure (2) supportant un niveau de métallisation (M1) du circuit intégré et la couche isolante supérieure (80) recouvrant ce niveau de métallisation (M1), et **par le fait que** la première électrode (40) est une partie d'une première couche métallique (4) formant ledit niveau de métallisation et la deuxième électrode (70, 71) est plus fine que la première électrode.

5. Circuit intégré selon la revendication 4, **caractérisé par le fait que** le métal de la première électrode (40), formé dans la première couche métallique, est de l'aluminium, **par le fait que** le métal de la deuxième électrode directement en contact avec la couche diélectrique est de l'aluminium ou du tungstène, et **par le fait que** le matériau diélectrique est choisi dans le groupe formé par SiO₂, Si₃N₄ et Ta₂O₅.

6. Circuit intégré selon la revendication 5, **caractérisé par le fait que** l'épaisseur de la première électrode (40) est de l'ordre de 0,7 micron, tandis que l'épaisseur de la couche diélectrique (6) est de l'ordre de 0,02 micron et que l'épaisseur de la deuxième électrode (70, 71) est comprise entre environ 0,05 et 0,1 micron.

7. Circuit intégré selon l'une des revendications 4 à 6, **caractérisé par le fait que** la première électrode comporte un flanc latéral (FL) recouvert d'une partie (60) de la couche diélectrique, elle-même recouverte d'une partie (70) de la deuxième électrode.

8. Circuit intégré selon l'une des revendications 4 à 7, **caractérisé par le fait qu'**il comporte un trou interconnexion métallique (120) ménagé dans ladite couche supérieure isolante (80) et reliant ladite deuxième électrode (71) à un niveau de métallisation supérieur (M2) du circuit intégré.

## Claims

1. Process for fabricating a metal-metal capacitor within an integrated circuit, the integrated circuit having metallization levels respectively supported by lower insulating layers (2) and covered by upper insulating layers (80), the said capacitor comprising two metal electrodes in contact with a dielectric layer on each side of the latter thinner than an insulating layer separating two metallization levels, **characterized in that** a first metal layer (4) forming a metallization level (M1) of the integrated circuit is deposited on top of a lower insulating layer (2), the said first layer (4) is etched so as to form a first electrode (40) of the capacitor, a thin layer (6) of a dielectric is deposited on the first layer thus etched, then a second metal layer (7) thinner than the first is deposited on the dielectric layer, which second metal layer is etched in order to form the second electrode (70, 71) of the capacitor, and an upper insulating layer (80) which covers the said metallization level (M1) is deposited on the second metal layer thus etched.

2. Process according to Claim 1, **characterized in that** at least one side wall (FL) for the said first electrode (40) is made when etching the first metal layer (4) and, after the dielectric layer (6) has been deposited on the said wall, the second metal layer deposited on the dielectric layer is etched so as to produce, for the second electrode, a side portion (70) in contact with the dielectric layer (60) and facing the said side wall (FL).

3. Process according to either of the preceding claims, **characterized in that** an aperture (9) is etched in the upper insulating layer (80), which is filled with a filling metal (12) so as to form a metal via (120), and a third metal layer (140), corresponding to an upper metallization level (M2), is deposited on top of the said insulating layer (80) and on top of the metal via (120).

4. Integrated circuit, which includes metallization levels respectively supported by lower insulating layers (2) and covered by upper insulating layers (80), a metal-metal capacitor comprising two metal electrodes placed on each side of and in contact with a dielectric layer thinner than an insulating layer separating two metallization levels, **characterized in that** the two metal electrodes (40, 71) and the dielectric layer (61) lie between the lower insulating layer (2) which supports a metallization level (M1) of the integrated circuit and the upper insulating layer (80) which covers this metallization level (M1), and **in that** the first electrode (40) is a part of a first metal layer (4) forming the said metallization level and the second electrode (70, 71) is thinner than the first electrode.

5. Integrated circuit according to Claim 4, **characterized in that** the metal of the first electrode (40), formed in the first metal layer, is aluminium, **in that** the metal of the second electrode directly in contact with the dielectric layer is aluminium or tungsten and **in that** the dielectric is chosen from the group formed by SiO₂, Si₃N₄ and Ta₂O₅.

6. Integrated circuit according to Claim 5, **characterized in that** the thickness of the first electrode (40) is about 0.7 microns, while the thickness of the dielectric layer (6) is about 0.02 microns, and **in that** the thickness of the second electrode (70, 71) is between approximately 0.05 and 0.1 microns.

7. Integrated circuit according to one of Claims 4 to 6, **characterized in that** the first electrode has a side wall (FL) covered with a part (60) of the dielectric layer, this part (60) being covered with a part (70) of the second electrode.

8. Integrated circuit according to one of Claims 4 to 7, **characterized in that** it has a metal via (120) made in the said upper insulating layer (80) and connecting the said second electrode (71) to an upper metallization level (M2) of the integrated circuit.

## Patentansprüche

1. Verfahren zur Herstellung einer Metall-Metall-Kapazität in einer integrierten Schaltung, wobei die integrierte Schaltung Metallisierungsebenen aufweist, die jeweils von unteren Isolationsschichten (2) getragen werden und von oberen Isolationsschichten (80) bedeckt sind, wobei die Kapazität zwei Metallelektroden aufweist, die beiderseits einer dielektrischen Schicht im Kontakt sind, die dünner als eine Isolationsschicht ist, die zwei Metallisierungsebenen trennt, **gekennzeichnet durch** die Tatsache, daß
man oberhalb einer unteren Isolationsschicht (2) eine erste Metallschicht (4) aufbringt, die eine Metallisierungsebene (M1) der integrierten Schaltung bildet,
man die erste Schicht (4) auf eine Weise ätzt, um eine erste Elektrode (40) der Kapazität zu formen,
man auf die erste so geätzte Schicht die dünne Schicht (6) aus einem dielektrischen Material aufbringt,
man dann auf die dielektrische Schicht eine zweite Metallschicht (7), die dünner als die erste ist, aufbringt, die man ätzt, um die zweite Elektrode (70,71) der Kapazität zu formen, und
man auf die zweite so geätzte Metallschicht eine obere Isolationsschicht (80) aufbringt, die die Metallisierungsebene (M1) bedeckt.

2. Verfahren nach Anspruch 1, **gekennzeichnet durch** die Tatsache, daß man beim Ätzen der ersten Metallschicht (4) mindestens eine Seitenflanke (FL) für die erste Elektrode (40) ätzt und man nach dem Aufbringen der dielektrischen Schicht (6) auf diese Flanke die auf die dielektrische Schicht aufgebrachte zweite Metallschicht auf eine Weise ätzt, um für die zweite Elektrode einen seitlichen Abschnitt (70) herzustellen, der im Kontakt mit der dielektrischen Schicht (60) ist und der Seitenflanke (FL) gegenüberliegt.

3. Verfahren nach einem der vorstehenden Ansprüche, **gekennzeichnet durch** die Tatsache, daß man eine Öffnung (9) in die obere Isolationsschicht (80) ätzt, daß man sie mit einem Füllmetall (12) auf eine Weise füllt, um ein metallisches Verbindungsloch (120) zu formen, und man oberhalb der Isolationsschicht (80) und oberhalb des metallischen Verbindungslochs (120) eine dritte Metallschicht aufbringt, die einer oberen Metallisierungsebene (M2) entspricht.

4. Integrierte Schaltung mit Metallisierungsebenen, die jeweils von unteren Isolationsschichten (2) getragen werden und von oberen Isolationsschichten (80) bedeckt sind, und einer Metall-Metall-Kapazität, die zwei Metallelektroden aufweist, die beiderseits und im Kontakt mit einer dünnen dielektrischen Schicht angeordnet sind, die dünner ist, als eine Isolationsschicht, die zwei Metallisierungsebenen trennt, **gekennzeichnet durch** die Tatsache, daß sich die zwei Metallelektroden (40,71) und die dielektrische Schicht (61) zwischen der unteren Isolationsschicht (2), die eine Metallisierungsebene (M1) der integrierten Schaltung trägt, und der oberen Isolationsschicht (80) befinden, die diese Metallisierungsebene (M1) bedeckt, und **durch** die Tatsache, daß die erste Elektrode (40) ein Teil einer ersten Metallschicht (4) ist, die die Metallisierungsebene bildet, und die zweite Elektrode (70,71) dünner als die erste Elektrode ist.

5. Integrierte Schaltung nach Anspruch 4, **gekennzeichnet durch** die Tatsache, daß das Metall der in der ersten Metallschicht geformten ersten Elektrode (40) Aluminium ist, **durch** die Tatsache, daß das Metall der zweiten Elektrode, die direkt im Kontakt mit der dielektrischen Schicht ist, Aluminium oder Wolfram ist, und **durch** die Tatsache, daß das dielektrische Material aus der Gruppe bestehend aus SiO₂, Si₃N₄ und Ta₂O₅ gewählt ist.

6. Integrierte Schaltung nach Anspruch 5, **gekennzeichnet durch** die Tatsache, daß die Dicke der ersten Elektrode (40) in der Größenordnung von 0,7 Mikrometer ist, während die Dicke der dielektrischen Schicht (6) in der Größenordnung von 0,02 Mikrometer ist und die Dicke der zweiten Elektrode (70,71) zwischen ungefähr 0,05 und 0,1 Mikrometer ist.

7. Integrierte Schaltung nach einem der Ansprüche 4 bis 6, **gekennzeichnet durch** die Tatsache, daß die erste Elektrode eine Seitenflanke (FL) aufweist, die von einem Teil (60) der dielektrischen Schicht bedeckt ist, der selbst von einem Teil (70) der zweiten Elektrode bedeckt ist.

8. Integrierte Schaltung nach einem der Ansprüche 4 bis 7, **gekennzeichnet durch** die Tatsache, daß sie ein metallisches Verbindungsloch (120) aufweist, das in die obere Isolationsschicht gearbeitet ist und die zweite Elektrode (71) mit einer oberen Metallisierungsebene (M2) der integrierten Schaltung verbindet.
